# EUROPEAN PATENT APPLICATION

(11) **EP 3 270 428 A1**
(43) Date of publication of application: **17.01.2018**
(21) Application number: 15884638.6
(22) Date of filing: 15.06.2015
(51) Int. Cl.: H01L 33/58, G09F 9/33, H01L 33/00, H01L 33/54

(54) **LIGHT-EMITTING ELEMENT AND IMAGE DISPLAY DEVICE**

(30) Priority: 12.03.2015 JP 2015048954
(71) Applicant: Mitsubishi Electric Corporation, Chiyoda-ku Tokyo 100-8310 (JP)
(72) Inventor: KIRIDOSHI Satoru, Tokyo 100-8310 (JP); HANAMURA Toshiaki, Tokyo 100-8310 (JP); TERANISHI Masato, Tokyo 100-8310 (JP); NAKAGUCHI Keisuke, Tokyo 100-8310 (JP); KAWAGUCHI Hironobu, Tokyo 102-0073 (JP)
(74) Representative: Studio Torta S.p.A.
(86) International application number: PCT/JP2015/067204
(87) International publication number: WO 2016/143152

(57) **Abstract**

A light-emitting element (1) includes a casing (2) that includes a recess (6), an LED chip (3g) disposed on a bottom surface (6a) of the recess (6) of the casing (2), a sealing member (8) to close the recess (6) and permit passage of light emitted by the LED chip (3g). The sealing member (8) includes an interface (9) with a space external to the casing (2), the interface (9) includes an inclined portion at least at a peripheral edge portion of the sealing member (8), and the inclined portion gradually approaches a bottom surface (6a) of the recess (6) as the inclined portion gets farther away from an optical axis of the LED chip (3g).

## Description

### Technical Field

The present disclosure relates to a light-emitting element and a video display device including the light-emitting element.

### Background Art

A large-sized video display device with light-emitting elements arranged in a matrix of rows and columns on a display screen is often located outdoors, such as in a sports facility, on a building wall, or the like. The video display device displays text, pictures, and other images on the display screen by causing change in brightness and emission of each light-emitting element in accordance with an external input video signal (see, for example, Patent Literatures 1 and 2).

The light-emitting element for use in the video display device includes a light source, for example a light-emitting diode (LED) or the like, disposed in a bottom of a recess of a casing, and a transparent resin with which the recess is filled. Light rays emitted by the light source are transmitted through the transparent resin to the exterior. An interface between the transparent resin and a space external to the casing, that is, an emission surface of the light-emitting element is made flat (see, for example, Patent Literatures 3 and 4).

### Citation List

### Patent Literature

Patent Literature 1: Unexamined Japanese Patent Application Kokai Publication No. H11-305689
Patent Literature 2: Unexamined Japanese Patent Application Kokai Publication No. 2006-308713
Patent Literature 3: Unexamined Japanese Patent Application Kokai Publication No. 2012-109461
Patent Literature 4: Unexamined Japanese Patent Application Kokai Publication No. 2015-26871

### Summary of Invention

### Technical Problem

Since the transparent resin included in the light-emitting element has a refractive index greater than that of air, the light emitted by the light source is refracted when the light passes through the interface between the transparent resin and the external air. At a peripheral edge portion, in particular, that is apart from an optical axis of the light-emitting element, an incident angle of the light on the interface increases, and thus the refractive angle increases. The increased refractive angle degrades a directional characteristic of the light since the light emitted by the light-emitting element is spread over a wide range. The degraded directional characteristic of the light-emitting element is not preferable because the visual image quality of the video display device is degraded.

The more compact and thinner light-emitting element further increases the incident angle at the peripheral edge portion of the light-emitting element, which further increases the refractive angle and further degrades the directional characteristic. In addition, if the incident angle exceeds the critical angle, a total reflection occurs on the interface, which prevents the light emitted by the light source from exiting the casing. Consequently, a problem arises in that an actual amount of light of the light-emitting element decreases.

The present disclosure has been made based on the above-described background, and an objective of the present disclosure is to improve a directional characteristic of a light-emitting element. Another objective of the present disclosure is to increase an actual amount of light of the light-emitting element by preventing the total reflection on the interface. Yet another objective of the present disclosure is to improve image quality of an image displayed on the video display device.

### Solution to Problem

To achieve the foregoing objectives, the present disclosure provides a light-emitting element including a casing that includes a recess, a light source disposed in the recess of the casing, and a transparent member to close the recess and permit passage of light emitted by the light source. The transparent member includes an interface with a space external to the casing, and the interface inclines at least at a peripheral edge portion of the transparent member so as to gradually approach a bottom surface of the recess as the interface gets farther away from an optical axis of the light source.

### Advantageous Effects of Invention

According to the present disclosure, the interface between the transparent member and the external space includes, at least at the peripheral edge portion of the transparent member, an inclined surface that gradually approaches the bottom surface of the recess as the inclined surface gets farther away from the optical axis of the light source, and thus an incident angle of emission light that is incident on the interface is smaller at the peripheral edge portion of the transparent member. The smaller incident angle leads to a smaller refractive angle, which provides a smaller spreading range of light emission. This results in improvement of a directional characteristic of the light-emitting element. A selection of an inclination angle with a refractive angle smaller than the critical angle prevents occurrence of total reflection, which thus increases an actual amount of light of the light-emitting element. The video display device including the light-emitting element according to the present disclosure provides a bright and sharp image because of such improved directional characteristic of the light-emitting element and thus the increase in the actual amount of light. That is, the present disclosure provides improved image quality of the video display device.

### Brief Description of Drawings

FIG. 1A is a plan view of a light-emitting element according to an embodiment of the present disclosure;
FIG. 1B is a side view of the light-emitting element illustrated in FIG. 1A;
FIG. 1C is a cross-sectional view of the light-emitting element illustrated in FIG. 1A, taken along line A-A' of FIG. 1A;
FIG. 2 is a cross-sectional view illustrating an effect of the light-emitting element illustrated in FIGS. 1A to 1C;
FIG. 3 is a schematic diagram of a video display device according to an embodiment of the present disclosure;
FIG. 4 is a schematic diagram illustrating a use aspect of the video display device illustrated in FIG. 3;
FIG. 5 is a cross-sectional view illustrating a configuration of a light-emitting element according to a variation;
FIG. 6 is a side view illustrating a configuration of a light-emitting element according to another variation; and
FIG. 7 is a side view illustrating a configuration of a light-emitting element according to yet another embodiment.

### Description of Embodiments

Embodiments of a light-emitting element and a video display device according to the present disclosure are described below in detail with reference to the drawings. The same reference signs are used for the same or equivalent parts throughout the drawings.

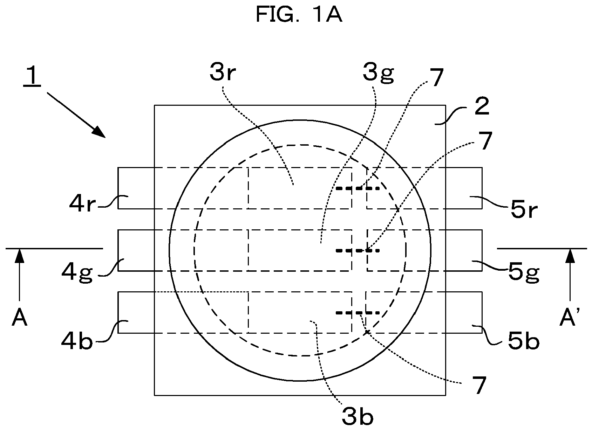

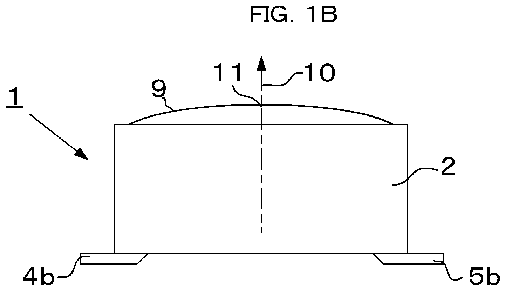

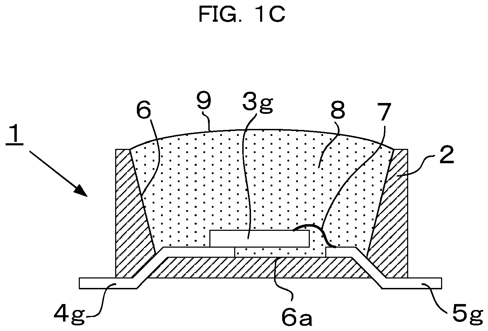

Each of FIGS. 1A to 1C is a schematic diagram of a light-emitting element 1 according to an embodiment of the present disclosure. FIG. 1A is a plan view of a light-emitting element 1, and FIG. 1B is a side view of the light-emitting element 1. FIG. 1C is a cross-sectional view of the light-emitting element 1, taken along line A-A' of FIG. 1A.

As illustrated in FIG. 1A, the light-emitting element 1 includes three LED chips 3r, 3g, and 3b that are housed in a casing 2 and serve as a light source of the light-emitting element 1. The LED chips 3r, 3g, and 3b include light-emitting diodes that emit red light, green light, and blue light, respectively. The light-emitting element 1 can provide various emission colors by changing emission intensities (brightness) of the LED chips 3r, 3g, and 3b. Three sets of extraction electrodes 4r, 5r; 4g, 5g; and 4b, 5b include ends exposed to the exterior of the casing 2. The casing 2, which is a resin molding forming a shell of the light-emitting element 1, holds the LED chips 3r, 3g, and 3b or the like. Examples of materials of the casing 2 include, but are not limited to, a thermoplastic resin, such as a polyphthalamide resin, and a thermosetting resin, such as a silicone resin and an epoxy resin.

As illustrated in FIG. 1C, a recess 6 is formed in the casing 2. The extraction electrodes 4g and 5g are disposed in the recess 6. The extraction electrodes 4g and 5g extend toward the outside of the casing 2, and the ends thereof are exposed the exterior of the casing 2 as described above. The extraction electrodes 4r, 5r, 4b, and 5b are also disposed similarly.

The LED chip 3g disposed in the recess 6 is mounted on the extraction electrode 4g, and electrically connected to the extraction electrode 4g. A bonding wire 7 has one end electrically connected to an upper surface of the LED chip 3g and another end electrically connected to the extraction electrode 5g. Similarly, the LED chips 3r and 3b are mounted on the respective extraction electrodes 4r and 4b, and electrically connected to the respective extraction electrodes 4r and 4b. The LED chips 3r and 3b are also electrically connected to the respective extraction electrodes 5r and 5b via the respective bonding wires 7. The recess 6 is filled with a transparent resin to form a sealing member 8. The sealing member 8, which is an example transparent member of the present disclosure, is a member for sealing the LED chips 3r, 3g, and 3b within the recess 6 by closing the recess 6. The sealing member 8 is a member for permitting passage of rays emitted by the LED chips 3r, 3g, and 3b. Examples of materials of the sealing member 8 include, but are not limited to, an epoxy resin and a silicone resin.

The sealing member 8 bulges outside the casing 2, and has a raised curved surface, which has a convex lens shape, forming an interface 9 with a space external to the light-emitting element 1. As illustrated in FIG. 1B, the interface 9 has a center that is an intersection 11 of the interface 9 and an optical axis 10 of the LED chip 3g, and the intersection 11 is located farthest away from a bottom surface 6a of the recess 6. The interface 9 inclines so as to approach the bottom surface 6a of the recess 6 as the interface 9 gets farther away from intersection 11. The inclination of the interface 9 increases with an increasing distance from the intersection 11. The inclination of the interface 9 appearing in the side view (FIG. 1B) and in the cross-sectional view (FIG. 1C) is maximal at the boundary between the interface 9 and the recess 6, that is, the peripheral edge portion of the sealing member 8. Thus the interface 9 of the sealing member 8 includes an inclined surface over the entire range from the intersection 11 with the optical axis 10 to the boundary with the recess 6, and the inclined surface gradually approaches the bottom surface 6a of the recess 6 as the inclined surface gets farther away from the optical axis 10.

The light-emitting element 1 is produced as in the following process. Firstly, the extraction electrodes 4r, 5r, 4g, 5g, 4b, and 5b are placed within a mold (not shown), and a resin is injected into the mold to mold the casing 2 while the extraction electrodes 4r, 5r, 4g, 5g, 4b, and 5b are fixed to the casing 2. As described above, the casing 2 can be, for example, made of a thermoplastic resin, such as a polyphthalamide resin, or a thermosetting resin, such as a silicone resin and an epoxy resin. Light-reflecting particles, such as titanium dioxide, may be mixed with the resin to improve optical reflectivity.

After the casing 2 is molded, the LED chips 3r, 3g, and 3b are bonded to the extraction electrodes 4r, 4g, and 4b within the recess 6 of the casing 2. Then the LED chips 3r, 3g, and 3b are electrically connected to the extraction electrodes 5r, 5g, and 5b via bonding wires 7.

Finally, a liquid transparent resin is injected into the recess 6 to form the sealing member 8. During the injection, an amount of resin in excess of the capacity of the recess 6 is injected into the recess 6 at a low rate. Injection of the resin at a low rate enables a liquid surface of the resin passing beyond the recess 6 to form a bulge in a convex lens shape under the action of surface tension. This bulging resin is left to set to form an interface 9 having a convex lens shape. As described above, the sealing member 8 can be, for example, made of an epoxy resin or a silicone resin.

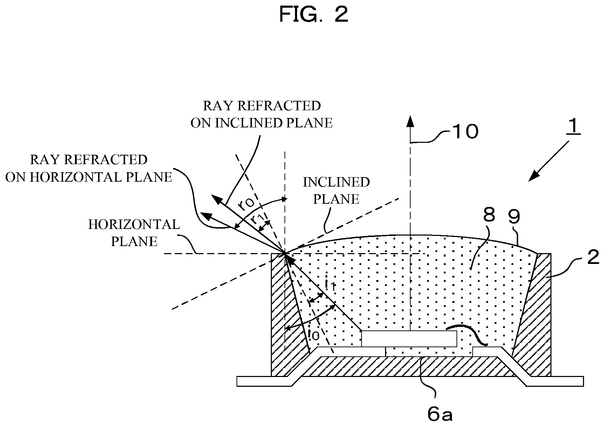

Next, the effects of the light-emitting element 1 are described with reference to FIG. 2. Assuming that the interface 9 of the sealing member 8 does not incline, that is, the interface 9 of the sealing member 8 is a horizontal plane as illustrated in FIG. 2, a ray emitted by the LED chip 3g enters the peripheral edge portion of the sealing member 8 at an incident angle *i0* and exits sealing member 8 at a refractive angle *r0*. The interface 9 of the actual sealing member 8 inclines relative to the bottom surface 6a of the recess 6 at the peripheral edge portion, that is, the interface 9 includes an inclined surface as illustrated in FIG. 2 at the peripheral edge portion. Thus the ray emitted by the LED chip 3g enters the peripheral edge portion of the sealing member 8 at an incident angle *i1* and exits the sealing member 8 at a refractive angle *r1.* Since the incident angle *i1* is smaller than the incident angle *i0,* the refractive angle *r1* is smaller than the refractive angle *r0.* Thus the ray passing through the inclined surface has a smaller inclination relative to the optical axis 10 than the ray otherwise passing through the horizontal plane. In this way, since the spreading range of the rays passing through the inclined surface is smaller than that of the rays otherwise passing through the horizontal surface, the directional characteristic is improved.

In addition, if the inclination of the inclined surface is set so that the incident angle *i0* is smaller than the critical angle of the material included in the sealing member 8, a total reflection does not occur on the interface 9 of the sealing member 8. In other words, proper setting of the inclination of the inclined surface prevents total reflection on the interface 9 and enables an increase in an actual amount of light of the light-emitting element 1.

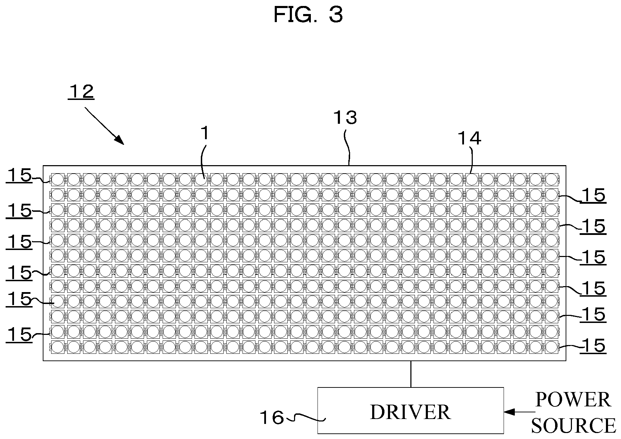

FIG. 3 is a schematic view of a video display device 12 according to an embodiment of the present disclosure. As illustrated in FIG. 3, a display screen 13 of the video display device 12 includes light-emitting elements 1 arranged in a matrix of rows and columns on a board 14. That is, the light-emitting elements 1 are arranged in a horizontal direction to form rows of light-emitting elements 15, and in a vertical direction to form columns of light-emitting elements 15. The board 14 includes unillustrated wiring patterns formed thereon, and the extraction electrodes 4r, 5r, 4g, 5g, 4b, and 5b (not shown in FIG. 3) of each light-emitting element 1 are connected to the respective wiring patterns.

The video display device 12 also includes a driver 16. The driver 16, which is connected to each light-emitting element 1 via the above-mentioned wiring patterns, is an electric circuit to distribute power supplied by a power source to light-emitting elements 1 and to individually adjust brightness and emission color of the light-emitting elements 1.

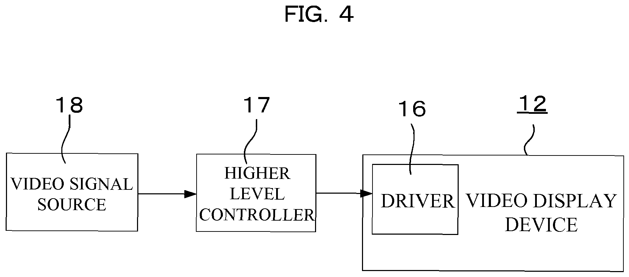

As illustrated in FIG. 4, the video display device 12 is used by connection to a video signal source 18 via a higher level controller 17. The video signal source 18 can be, for example, a server to output a prestored video signal to the higher level controller 17. The higher level controller 17, which is a computer, converts a video signal input by the video signal source 18 in accordance with an arrangement of the light-emitting elements 1 in the video display device 12, determines the brightness and emission color of the individual light-emitting element 1, and outputs the video signal to to the driver 16.

In this way, the video display device 12 individually adjusts the brightness and emission color of the light-emitting elements 1 arranged on the board 14, and displays an image on the display screen 13. Then, the video display device 12 displays a moving image (video) by changing the image over time. The display screen 13 of the video display device 12 corresponds to a screen of a small-sized video display device, for example a liquid crystal display, and a single light-emitting element 1 corresponds to a single pixel.

As described above, the light-emitting element 1 has the improved directional characteristic and the total reflection is prevented, and thus the actual amount of light is increased, thereby providing a sharp and bright image for the video display device 12. Briefly, the inclusion of the light-emitting element 1 in the video display device 12 provides improved image quality of the video display device 12.

As described above, the present disclosure provides the improved directional characteristic of the light-emitting element because the smaller incident angle of the rays on the interface of the transparent member emitted by the light source of the light-emitting element results in a smaller refractive angle. In addition, setting of the incident angle to be smaller than the critical angle prevents the total reflection and increases an actual amount of the light of the light-emitting element. The video display device including the light-emitting element according to the present disclosure improves the image quality of the video display device because of such improved directional characteristic of the light-emitting element and the increase in the actual amount of light.

The above embodiments describe some examples of specific embodiments of the present disclosure, and the technical scope of the present disclosure is not limited by the embodiments. Any variation or modification can be made within the scope of the technical idea as that defined in the claims to implement the present disclosure. Any addition of elements that are not disclosed in the above embodiments is to be allowed.

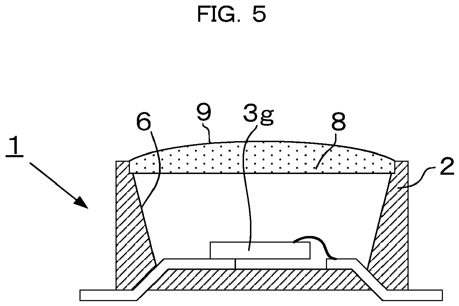

For example, the above embodiments provide an example process of forming the transparent member by injecting a liquid resin into the recess 6 of the casing 2, filling the recess 6 with the liquid resin, and then setting the liquid resin to form the sealing member 8, but the transparent member is not limited to the member produced by the process. For example, as illustrated in FIG. 5, a sealing member 8 produced in another process, that is, an already solidified sealing member 8 may be fitted in the recess 6.

The above embodiments provide examples of the interface 9 of the sealing member 8 formed in a convex lens shape. In other words, the above embodiments provide examples of the interface 9 of the sealing member 8 having the inclined surface formed over the entire range of the interface so as to gradually approach the bottom surface 6a of the recess 6 as the inclined surface gets farther away from the optical axis 10, and furthermore so as to have greater inclination relative to the bottom surface 6a as the inclined surface gets farther away from the optical axis 10. However, the shape of the interface 9 is not limited to such a shape.

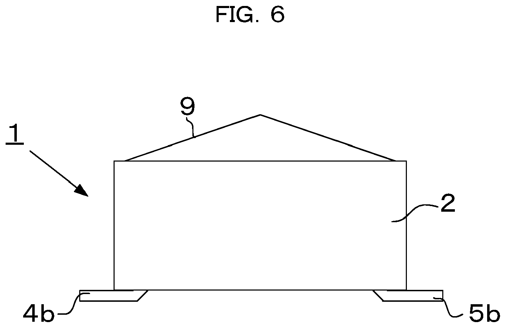

The inclination of the interface 9 may be constant regardless of the distance from the optical axis 10. For example, as illustrated in FIG. 6, the interface 9 of the sealing member 8 may form a conical surface.

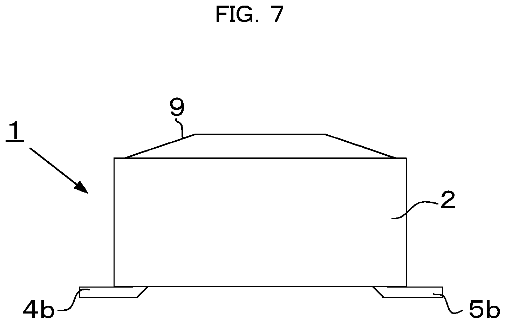

In addition, forming the inclined surface only at a portion having a greater incident angle among portions in the interface 9 is sufficient. Forming the inclined surface only at the portion far away from the optical axis 10, that is, at the peripheral edge portion of the interface 9 is sufficient. This is because any flat portion in the interface 9 that is not far away from the optical axis 10 does not provide great refraction due to the small incident angle. For example, as illustrated in FIG. 7, the interface 9 of the sealing member 8 may form a truncated-cone shape.

The number of LED chips 3r, 3g, and 3b included in the light-emitting element 1 is not limited to three. The number may be one, two, or four or more. The emission color of the light-emitting element 1 is not limiting. Any combination of emission colors is possible. A chip including light-emitting diodes having different emission colors may be provided on a single board as a light source.

Although the higher level controller 17 is provided as an external device of the video display device 12 in the above embodiments, the higher level controller 17 may be incorporated into the video display device 12.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

This application claims the benefit of Japanese Patent Application No. 2015-048954, filed on March 12, 2015, the entire disclosure of which is incorporated by reference herein.

### Reference Signs List

- 1: Light-emitting element
- 2: Casing
- 3r, 3g,: 3b LED chip
- 4r, 4g, 4b, 5r, 5g, 5b: Extraction electrode
- 6: Recess
- 6a: Bottom surface
- 7: Bonding wire
- 8: Sealing member
- 9: Interface
- 10: Optical axis
- 11: Intersection
- 12: Video display device
- 13: Display screen
- 14: Board
- 15: Rows and columns of light-emitting elements
- 16: Driver
- 17: Higher level controller
- 18: Video signal source

## Claims

1. A light-emitting element, comprising:
a casing including a recess;
a light source disposed in the recess of the casing; and
a transparent member to close the recess and permit passage of light emitted by the light source,
the transparent member including an interface with a space external to the casing, the interface including an inclined portion at least at a peripheral edge portion of the transparent member, the inclined portion gradually approaching a bottom surface of the recess as the inclined portion gets farther away from an optical axis of the light source.

2. The light-emitting element according to claim 1, wherein the interface is a convex-lens shaped surface.

3. The light-emitting element according to claim 1, wherein the interface is a conical shaped surface.

4. The light-emitting element according to claim 1, wherein the interface is a truncated-cone shaped surface.

5. A video display device comprising a plurality of the light-emitting elements according to any one of claims 1 to 4, wherein the plurality of the light-emitting elements are arranged in a matrix of rows and columns.
